# EUROPEAN PATENT SPECIFICATION

(11) **EP 4 553 976 B1**
(45) Date of publication and mention of the grant of the patent: **20.05.2026**
(21) Application number: 23855164.2
(22) Date of filing: 17.08.2023
(51) Int. Cl.: A62C 3/16, G01R 19/165, H01M 50/682, H01M 10/48

(54) **BATTERY FIRE EXTINGUISHING DEVICE AND OPERATING METHOD THEREOF**
BATTERIEFEUERLÖSCHVORRICHTUNG UND BETRIEBSVERFAHREN DAFÜR
DISPOSITIF D'EXTINCTION D'INCENDIE DE BATTERIE ET SON PROCÉDÉ DE FONCTIONNEMENT

(30) Priority: 17.08.2022 KR 20220103000
(43) Date of publication of application: 14.05.2025
(73) Proprietor: LG Energy Solution, Ltd., Seoul 07335 (KR)
(72) Inventor: KIM, Do Yul, Daejeon 34122 (KR)
(74) Representative: Hoffmann Eitle
(86) International application number: PCT/KR2023/012188
(87) International publication number: WO 2024/039198

(56) References cited:
- JP-A- 2016 002 419
- JP-A- 2020 047 606
- KR-A- 20210 017 842
- KR-A- 20210 141 806
- KR-A- 20220 090 635

## Description

### [TECHNICAL FIELD]

### TECHNICAL FIELD

Embodiments disclosed herein relate to a battery fire-extinguishing apparatus and an operating method thereof.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. Among them, a lithium-ion battery has a much higher energy density than those of conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

With the recently increasing utilization of large-capacity batteries such as electric vehicles, etc., battery safety issues have emerged. In particular, explosion of a battery module or occurrence of fire for some reasons may directly lead to a serious casualty accident, making it important not only to monitor the state of the battery in real time, but also to minimize damage by extinguishing ignition of the battery module early upon occurrence the ignition of the battery module. Nevertheless, an existing battery module not only has no countermeasures against abnormal ignition, but also has no technique for preventing thermal runaway by taking action in adjacent other battery modules when fire occurs in some battery module.
KR 2021 0141806 A describes a battery pack comprising a means configured to, when an abnormal phenomenon, such as fire outbreak or heat generation, occurs in a battery cell, prevent fire or heat from propagating to another battery cell adjacent thereto. The battery pack comprises: a plurality of battery cells; a case configured to receive the plurality of battery cells; an energy discharging means configured to discharge energy of the battery pack when the abnormal phenomenon occurs; and a fire extinguishing means configured to discharge aerosol at an operating temperature or higher in order to extinguish flames generated in the battery pack.

### [DISCLOSURE]

### [TECHNICAL PROBLEM]

Embodiments disclosed herein aim to provide a battery fire-extinguishing apparatus and an operating method thereof in which when fire occurs in some battery module of a battery pack, ignition may be suppressed using fire-extinguishing fluid and heat spread to other battery modules may be prevented.

Technical problems of the embodiments disclosed herein are not limited to the above-described technical problems, and other unmentioned technical problems would be clearly understood by one of ordinary skill in the art from the following description.

### [TECHNICAL SOLUTION]

This object is accomplished by the subject-matter of the independent claims. The dependent claims concern particular embodiments.

### [ADVANTAGEOUS EFFECTS]

According to the proposed battery fire-extinguishing apparatus, when fire occurs in some battery module of a battery pack, fire-extinguishing fluid may be automatically discharged to suppress fire ignition.

Moreover, when fire occurs in some battery module, fire-extinguishing fluid may be automatically discharged into all other battery modules to prevent heat from spreading to the other battery modules.

Moreover, various effects recognized directly or indirectly from the disclosure may be provided.

### [DESCRIPTION OF DRAWINGS]

In order to more clearly describe technical solutions of embodiments disclosed herein or the prior art, the drawings required in the description of the embodiments are briefly introduced below. It should be understood that the following drawings are for the purpose of explaining the embodiments of the present specification and not for limiting purposes. In addition, representations of some components in the drawings may be exaggerated or omitted for clarity of explanation.
FIG. 1 shows a structure of a battery module in which a battery fire-extinguishing apparatus according to an embodiment is installed.
FIG. 2 shows an equivalent circuit structure of a battery fire-extinguishing apparatus according to an embodiment.
FIGS. 3A to 3D show an operating process of a battery fire-extinguishing apparatus according to an embodiment operates.
FIG. 4 is a flowchart showing an operating method of a battery fire-extinguishing apparatus according to an embodiment.
FIG. 5 is a flowchart showing an operating method of a battery fire-extinguishing apparatus according to another embodiment.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof may be omitted.

Although terms used herein are selected with general terms popularly used at present under the consideration of functions in the disclosure, the terms may vary according to the intention of those of ordinary skill in the art, custom, or introduction of new technology. In addition, in a specific case, the applicant voluntarily may select terms, and in this case, the meaning of the terms may be disclosed in a corresponding description part of the present specification. Therefore, the terms used herein should be defined not by the simple names of the terms but by the substantial meaning of the terms and the contents throughout the disclosure.

Moreover, terms defined in the present disclosure are used for only describing a specific exemplary embodiment and may not have an intention to limit the scope of other exemplary embodiments. It is to be understood that the singular forms include plural references unless the context clearly dictates otherwise. Herein, expressions such as "first" and "second" are used to distinguish components from each other, and do not mean a rank or order among components.

Hereinbelow, preferred embodiments of a battery fire-extinguishing apparatus and an operating method thereof will be described with reference to the drawings.

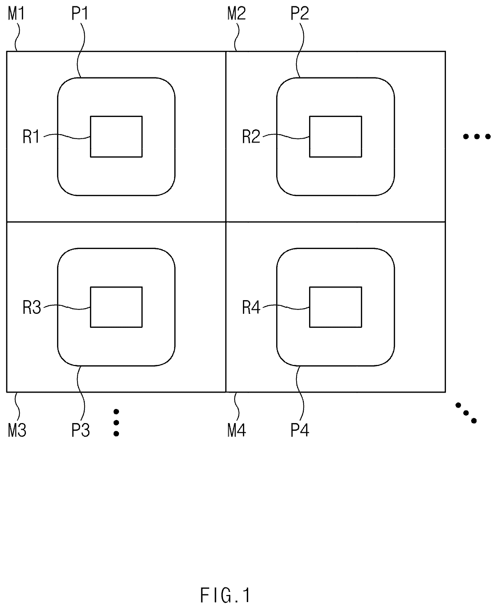

FIG. 1 shows a structure of a battery module in which a battery fire-extinguishing apparatus according to an embodiment is installed.

A battery pack used as a power source for an electronic device such as an electric vehicle, etc., includes a plurality of battery modules, each of which may include one or more battery cells. A battery cell is a component that is repeatedly chargeable/dischargeable and is capable of generating a potential difference through an electrochemical reaction. A battery cell may include a positive electrode, a negative electrode, a separator, and an electrolyte, and when internal short circuit occurs due to the absence of the separator, introduction of foreign metal substances, internal deformation, damage to the separator, etc., or overheating occurs due to abnormality of a control system, fire may occur due to a battery cell. Fire occurring in some battery cells may be spread to fire of other battery cells or battery modules where the battery cells are located, and fire occurring in some battery module may be spread to fire of other battery modules and the entire battery pack.

Referring to FIG. 1, a battery pack may include a plurality of battery modules M1, M2, M3, M4, ..., and a battery fire-extinguishing apparatus according to an embodiment includes a plurality of fire-extinguishing fluid storing units P1, P2, P3, P4, ..., respectively located in the plurality of battery modules M1, M2, M3, M4, ..., a plurality of resistor units R1, R2, R3, R4, ..., adjacent respectively to the plurality of fire-extinguishing fluid storing units P1, P2, P3, P4, ..., and a control circuit 10 for controlling current flowing through the plurality of resistor units R1, R2, R3, R4, ....

The fire-extinguishing fluid storing units P1, P2, P3, P4, ..., are respectively located in battery modules M1, M2, M3, M4, .... According to an embodiment, each fire-extinguishing fluid storing unit may include a pouch that bursts when heated at a certain temperature or more, and the fire-extinguishing fluid discharged from the fire-extinguishing fluid storing unit may include a material for preventing an electrolyte gas in the battery module from contacting oxygen to lower a temperature in the battery module. Thus, if fire occurs in the battery module or the battery module is excessively heated, the fire-extinguishing fluid storing unit in the battery module may burst to discharge the fire-extinguishing fluid, thus suppressing fire ignition.

The resistor units R1, R2, R3, R4, ..., are respectively disposed adjacent to the fire-extinguishing fluid storing units P1, P2, P3, P4, ..., and may be preferably attached to the surface of the fire-extinguishing fluid storing unit (pouch). The resistor units R1, R2, R3, R4, ... may be electrically connected to one another in parallel and resistance heat may be generated depending on current flowing through the resistor units. Moreover, each resistor unit includes a heating pad that is destroyed when heated at a certain temperature or more, and opens a connected circuit when the heating pad is destroyed.

Assuming that some (e.g., M1) of the battery modules M1, M2, M3, M4, ... is overheated at a certain temperature or more or fire occurs, the fire-extinguishing fluid storing unit P1 may burst to suppress fire ignition of the battery module M1 and at the same time other resistors R2, R3, R4, ... connected to the resistor R1 in parallel may be heated to burst adjacent fire-extinguishing fluid storing units P2, P3, P4, ..., thereby suppressing or preventing fire ignition of the other battery modules M2, M3, M4, ....

The control circuit 10 monitors voltage across both ends of the plurality of resistor units R1, R2, R3, R4, ... and increase current flowing through each resistor unit when the voltage is higher than a reference voltage, thereby inducing destruction of the fire-extinguishing fluid storing unit adjacent to each resistor unit. A detailed operating method of the control circuit 10 will be described later.

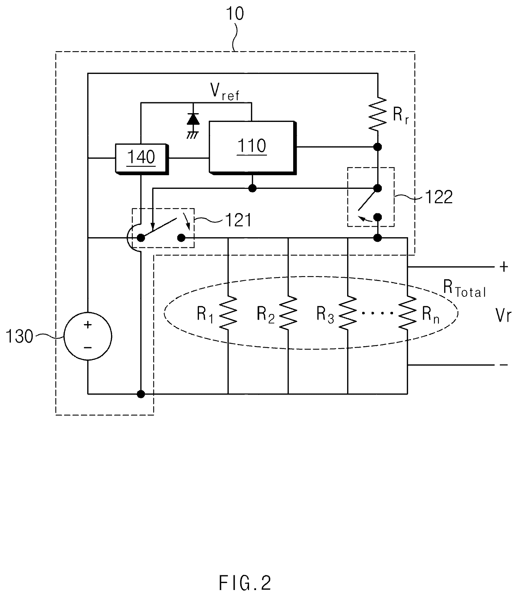

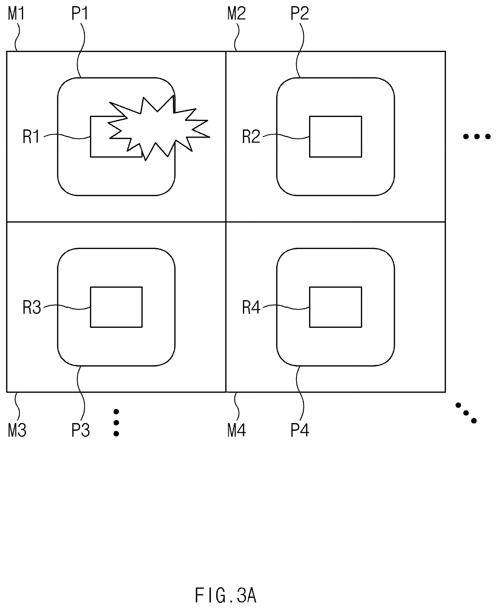

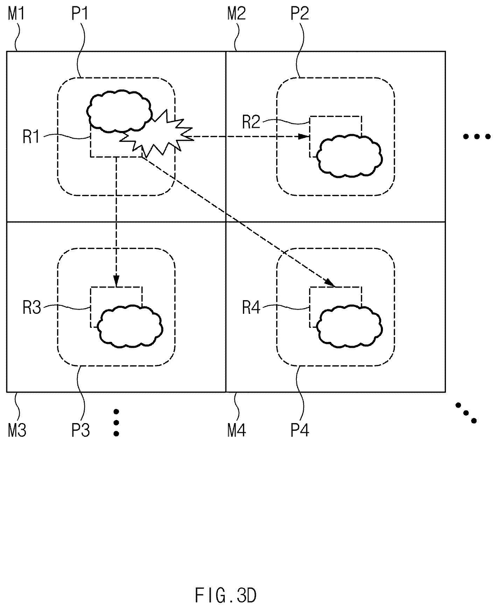

Hereinbelow, with reference to FIGS. 2 and 3A to 3D, an operating principle for suppressing fire ignition in other battery modules adjacent to a battery module where fire occurs will be described.

FIG. 2 shows an equivalent circuit structure of a battery fire-extinguishing apparatus according to an embodiment.

Referring to FIG. 2, the control circuit 10 of the battery fire-extinguishing apparatus may include a comparator 110 for comparing voltage at both ends of the resistor units R1, R2, R3, ..., Rn with a reference voltage Vref, at least one switches 121 and 122 for electrically connecting or disconnecting a resistor unit to or from a serial resistor, and a power supply unit 130 for supplying power to the circuit.

The comparator 110 may compare a voltage Vr across both ends of the resistor units R1, R2, R3, ..., Rn with the reference voltage Vref and open or close the switches 121 and 122 of the circuit according to a result of comparison to connect or disconnect a serial resistor Rr to or from the resistor units R1, R2, R3, ....

In a normal state where fire does not occur in the battery module or the battery module is not overheated, the plurality of resistor units R1, R2, R3, ..., Rn are connected to one another in parallel and all ends of the resistor units may be serially connected to the serial resistor Rr. Herein, the serial resistor Rr may have a resistance value greater than a total resistance R_{Total} of the resistor units R1, R2, R3, ..., Rn. For example, each of the plurality of resistor units R1, R2, R3, ..., Rn may have a resistance value of several to several tens of ohms, and the serial resistor Rr may have a resistance value of several hundreds of kilo-ohms. Moreover, the serial resistor Rr is shown as a single resistor element in FIG. 2, but may also include a plurality of resistors connected in series. In such a normal state, a high voltage may be applied to a serial resistor having a great resistance value according to a voltage distribution principle, and a total resistance value R_{Total}+Rr of the circuit is very great, such that a small amount of current may flow through the resistor units R1, R2, R3, ..., Rn.

More specifically, referring to FIG. 2, when fire does not occur (i.e., any resistance of a resistor unit is not removed), the voltage Vr across both ends of the resistor unit may be less than the reference voltage Vref, and the switch 121 may maintain an open state and the switch 122 may maintain a closed state. Thus, the resistors R1, R2, R3, ..., Rn may be serially connected to the serial resistor Rr, and most of voltage supplied to the power supply unit 130 may be applied to the serial resistor Rr.

Meanwhile, in an abnormal state where fire occurs in the battery module or the battery module is overheated at a certain temperature or more, for example, when fire occurs in an nth battery module among a plurality of battery modules, the fire-extinguishing fluid storing unit located in the battery module and the resistor unit Rn adjacent thereto may be destroyed by heating. At this time, as the fire-extinguishing fluid stored in the fire-extinguishing fluid storing unit is spread, heat generation in the module may be automatically suppressed, but when the fire-extinguishing fluid is not sufficient to completely suppress heat generation, heat generation may be spread to adjacent other modules, resulting in chain fire. According to a proposed embodiment, chain thermal runaway may be prevented using a method described below.

When a heating pad included in the resistor unit Rn is destroyed due to fire in a specific battery module, a circuit of the corresponding portion is opened. Referring to FIG. 2, some Rn of the plurality of resistor units R1, R2, R3, ..., Rn connected in parallel may be removed to increase the total resistance R_{Total} of the ends of the resistor units, such that the voltage Vr across both ends of the resistor units may also increase (the principle of voltage distribution).

Also in this case, the voltage Vr at both ends of the resistor units is much lower than the voltage across both ends of the serial resistor Rr (due to a resistance value difference), but when the voltage Vr across the both ends of the resistor units is greater than the reference voltage Vref, the switch 121 may switch to the closed state and the switch 122 may switch to the open state according to a result of comparison of the comparator 110. Due to an operation of the switch, the resistors R1, R2, R3, ..., and the serial resistor Rr may be electrically disconnected, and most of the voltage supplied by the power supply unit 130 may be applied to the resistor units R1, R2, R3, ....

Thus, the voltage across the both ends of the resistor units R1, R2, R3, ... may greatly increase when compared to the normal state, and current flowing through each resistor unit may greatly increase. As current flowing through the resistor units increases, a heat generation amount of the heating pad of each resistor unit may also increase and an adjacent fire-extinguishing fluid storing unit (or having attached thereto the heating pad) may discharge the fire-extinguishing fluid at a certain temperature or more.

In other words, when fire occurs in some battery module, this may lead to destruction of the resistor unit in the battery module and opening of the circuit, and due to switch control of the comparator 110 that monitors voltage change over all ends of the resistor units, voltage and current amount applied to all the ends of the resistor units may largely increase. As a result, by increasing heat generation of the resistor (heating pad) in the battery module where fire does not occur, and inducing destruction of the fire-extinguishing fluid storing unit, thermal explosion of the entire battery pack may be suppressed.

According to an embodiment, the control circuit 10 of the battery fire-extinguishing apparatus may further include a regulator 140 for maintaining voltage supplied from the power supply unit 130 at a certain level to supply the voltage to the comparator 110.

FIGS. 3A to 3D show an operating process of a battery fire-extinguishing apparatus according to an embodiment operates.

FIG. 3A shows the plurality of battery modules M1, M2, M3, M4, ..., the plurality of fire-extinguishing fluid storing units P1, P2, P3, P4, ... respectively located in the plurality of battery modules M1, M2, M3, M4, ..., and the plurality of resistor units R1, R2, R3, R4, ... respectively adjacent or attached to the plurality of fire-extinguishing fluid storing units. As described above, the resistor units R1, R2, R3, R4, ... are connected in parallel on an equivalent circuit.

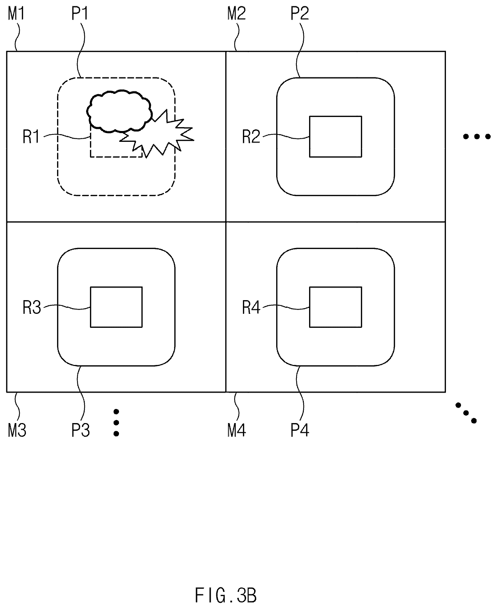

When fire occurs due to abnormality of a battery cell (e.g., internal shortcircuit, abnormality of a control system, etc.) in some battery module M1 as shown in FIG. 3A, the fire-extinguishing fluid storing unit P1 and the resistor unit R1 in the corresponding module M1 may be destroyed by heating and thus the fire-extinguishing fluid stored in the fire-extinguishing fluid storing unit P1 may be discharged, as shown in FIG. 3B, thereby extinguishing the fire and suppressing heat generation in the battery module M1.

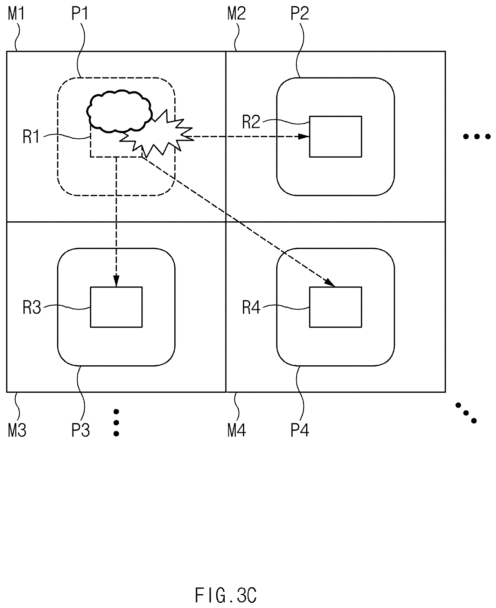

Moreover, as shown in FIG. 3C, opening of the circuit, caused by destruction of the resistor unit R1, may increase voltage applied to the other resistor units R2, R3, R4, ..., and current flowing through each resistor unit, and the heating pad included in the resistor units R2, R3, R4, ... may be rapidly heated.

As a result, the fire-extinguishing fluid storing units P2, P3, P4, ..., respectively adjacent to or attached to the resistor units R2, R3, R4, ... may also be heated, and pouches burst at a certain temperature or more, thus discharging fire-extinguishing fluid. Thus, heat generation in the other battery modules M2, M3, M4, ..., than the battery module M1 where fire occurs may be suppressed and thermal explosion of the entire battery pack may be prevented.

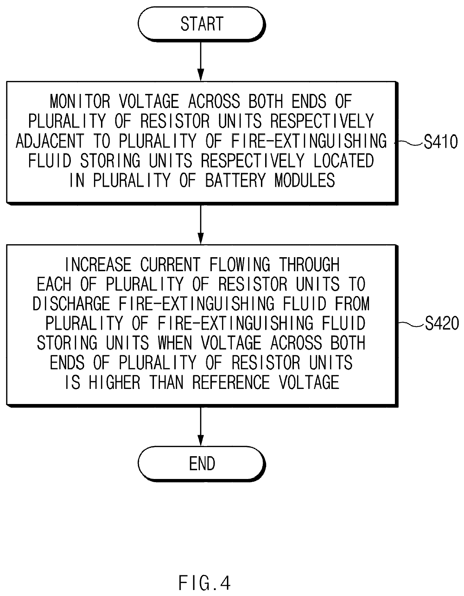

FIG. 4 is a flowchart showing an operating method of a battery fire-extinguishing apparatus according to an embodiment. The method according to an embodiment may be performed by the battery fire-extinguishing apparatus described above with reference to FIGS. 1 to 3, but the present disclosure is not limited thereto and may be performed by a battery fire-extinguishing apparatus having other structures or forms.

Referring to FIG. 4, in operation S410, voltage across both ends of a plurality of resistor units respectively adjacent to a plurality of fire-extinguishing fluid storing units respectively located in a plurality of battery modules may be monitored.

As described with reference to FIG. 1, the battery pack may include the plurality of battery modules M1, M2, M3, M4, ..., the plurality of fire-extinguishing fluid storing units P1, P2, P3, P4, ... are respectively located in the battery modules, and the plurality of resistor units R1, R2, R, R4, ... are respectively adjacent to or attached to the fire-extinguishing fluid storing units.

According to an embodiment, the plurality of resistor units are electrically connected to one another in parallel, and each resistor unit includes a heating pad that is destroyed by heating to open the connected circuit. When fire occurs in some battery module, a fire-extinguishing fluid storing unit in the corresponding module bursts to discharge fire-extinguishing fluid and thus suppress heat generation, and at the same time, a heating pad of a resistor unit is destroyed to open a circuit and change voltage across all ends of resistors connected in parallel.

In operation S420, when voltage across both ends of the plurality of resistor units (the other resistor units than the destroyed resistor unit) is higher than a reference voltage, current flowing through each of the plurality of resistor units may increase to heat the resistor unit, thus discharging fire-extinguishing fluid from a plurality of fire-extinguishing fluid storing units adjacent thereto. Thus, the fire-extinguishing fluid may suppress heat generation in the other battery modules than the battery module where fire occurs, and thermal explosion of the entire battery pack may be prevented.

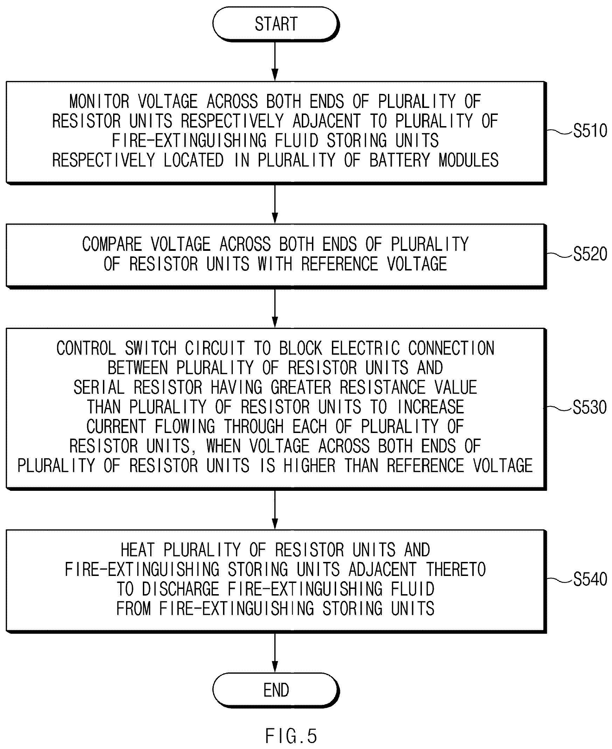

FIG. 5 is a flowchart showing an operating method of a battery fire-extinguishing apparatus according to another embodiment.

Referring to FIG. 5, in operation S510, voltage across both ends of a plurality of resistor units respectively adjacent to a plurality of fire-extinguishing fluid storing units respectively located in a plurality of battery modules may be monitored. Operation S510 is similar to operation S410 of FIG. 4 and thus will not be described in detail.

In operation S520, the voltage across both ends of the plurality of resistor units may be compared with the reference voltage. Operation S520 may be performed by the comparator 110 described with reference to FIG. 2, and when some of the plurality of resistor units connected in parallel are destroyed to open the circuit, thus increasing voltage across all the ends of the plurality of resistor units.

In operation S530, when the voltage across the both ends of the plurality of resistor units is higher than the reference voltage, a switch circuit may be controlled to block electric connection between the plurality of resistor units and a serial resistor having the greater resistance value than the plurality of resistor units, thereby increasing current flowing through each of the plurality of resistor units.

According to an embodiment, each of the plurality of resistor units may have a resistance value of several to several tens of ohms, and the serial resistor may have a resistance value of several hundreds of kilo-ohms. Thus, in the normal state (that is, a state where fire does not occur in any battery module), most voltage may be applied to the serial resistor having the greater resistance value and a small amount of current may flow through the plurality of resistor units.

On the other hand, in the abnormal state (a state where fire occurs in some battery module and thus some resistor unit is destroyed), the voltage across both ends of the resistor unit may be higher than the reference voltage and the switch may be opened and closed by the output signal from the comparator (110 of FIG. 2) to disconnect the serial resistor from the resistor unit and increase the current flowing through each of the plurality of resistor units.

In operation S540, the plurality of resistor units and adjacent fire-extinguishing fluid storing units adjacent thereto may be heated to discharge fire-extinguishing fluid from the fire-extinguishing fluid storing units. More specifically, as the serial resistor and the resistor unit are electrically disconnected, most of the voltage supplied from the power supply unit may be applied to the resistor unit, inducing increase of the current flowing through the resistor unit and heating of the heating pad. As a result, the fire-extinguishing fluid storing unit adjacent to the resistor unit or having attached thereto the resistor unit may burst due to heating to discharge the fire-extinguishing fluid and prevent heat spread to the battery module where fire does not occur.

The operating method of the battery fire-extinguishing apparatus according to the embodiment may be implemented in the form of an application or a program instruction that is executable through various computer components and recorded in a computer-readable recording medium. The computer-readable recording medium may include a program instruction, a data file, a data structure and the like solely or in a combined manner.

According to the foregoing embodiments, when fire occurs in some battery module of a battery pack, fire-extinguishing fluid may be discharged to suppress ignition, and fire-extinguishing fluid may be automatically discharged into all the other battery modules, thereby preventing heat spread to the other battery modules. Therefore, it is possible to prevent the battery pack from exploding due to an unexpected accident or result in a big fire.

So far, all components constituting the embodiment have been described as being combined or operating in combination, but it is not necessarily limited to this embodiment, and within the scope of the purpose, all components may be selectively combined with one or more to operate. Moreover, terms such as "include", "constitute", "have", etc., described above may mean that the corresponding component may be inherent unless otherwise stated, and thus should be construed as further including other components rather than excluding other components.

## Claims

1. A battery fire-extinguishing apparatus comprising:
a plurality of fire-extinguishing fluid storing units (P1, P2, P3, P4) respectively located in a plurality of battery modules (M1, M2, M3, M4) and configured to discharge fire-extinguishing fluid by heating;
a plurality of resistor units (R1, R2, R3, R4) respectively adjacent to the plurality of fire-extinguishing fluid storing units (P1, P2, P3, P4); and
a control circuit (10) configured to monitor voltage (Vᵣ) across both ends of the plurality of resistor units (R1, R2, R3, R4) and increase current flowing through each of the plurality of resistor units (R1, R2, R3, R4) when the voltage is higher than a reference voltage (V_{ref}), wherein
the plurality of resistor units (R1, R2, R3, R4) are electrically connected to one another in parallel, and each resistor unit comprises a heating pad that is destroyed by heating to open the connected circuit, and
the voltage across the both ends of the plurality of resistor units (R1, R2, R3, R4) is higher than the reference voltage when the heating pad included in at least one of the plurality of resistor units is destroyed.

2. The battery fire-extinguishing apparatus of claim 1, wherein a fire-extinguishing fluid storing unit (P1, P2, P3, P4) adjacent to each resistor unit is configured to discharge fire-extinguishing fluid by heating, when the current flowing through each of the plurality of resistor units increases.

3. The battery fire-extinguishing apparatus of claim 1, wherein the fire-extinguishing fluid comprises a material that prevents an electrolyte gas in the battery module from contacting oxygen and lowers a temperature in the battery module.

4. The battery fire-extinguishing apparatus of claim 1, wherein the control circuit (10) comprises:
a comparator (110) configured to compare the voltage across both ends of the plurality of resistor units with the reference voltage;
a serial resistor (Rᵣ) serially connected to the plurality of resistor units;
a power supply unit (130) configured to supply power to the plurality of resistor units and the circuit connected to the serial resistor; and
at least one switch (121, 122) configured to electrically connect or disconnect the plurality of resistor units (R1, R2, R3, R4) to or from the serial resistor (Rᵣ),
wherein, when the voltage across the both ends of the plurality of resistor units (R1, R2, R3, R4) is higher than the reference voltage (V_{ref}), electric connection between the plurality of resistors and the serial resistor is blocked to increase the current flowing through each of the plurality of resistor units.

5. The battery fire-extinguishing apparatus of claim 4, wherein the serial resistor (Rᵣ) has a greater resistance value than a total resistance value of the plurality of resistor units (R1, R2, R3, R4).

6. The battery fire-extinguishing apparatus of claim 4, wherein the control circuit (10) further comprises a regulator (140) configured to maintain voltage supplied from the power supply unit at a certain level and supply the voltage to the comparator.

7. An operating method of a battery fire-extinguishing apparatus of claim 1, the operating method comprising:
Monitoring (S410) voltage across both ends of a plurality of resistor units respectively adjacent to a plurality of fire-extinguishing fluid storing units respectively located in a plurality of battery modules; and
Increasing (S420) current flowing through each of the plurality of resistor units when voltage is higher than a reference voltage.

8. The operating method of claim 9, wherein the increasing of the current flowing through each of the plurality of resistor units comprises:
Comparing (S520) the voltage across both ends of the plurality of resistor units with the reference voltage; and
Controlling (S530) a switch circuit to block electric connection between the plurality of resistor units and a serial resistor having a greater resistance value than the plurality of resistor units, when the voltage across the both ends of the plurality of resistor units is higher than the reference voltage.

9. The operating method of claim 8, further comprising heating (S540) the plurality of resistor units and the fire-extinguishing fluid storing unit to discharge fire-extinguishing fluid from the fire-extinguishing fluid storing unit.

## Patentansprüche

1. Batteriefeuerlöschvorrichtung umfassend:
eine Vielzahl von Feuerlöschfluidspeichereinheiten (P1, P2, P3, P4), die jeweils in einem der Vielzahl von Batteriemodulen (M1, M2, M3, M4) angeordnet sind und ausgebildet sind, durch Erhitzen Feuerlöschfluid abzugeben;
eine Vielzahl von Widerstandseinheiten (R1, R2, R3, R4), die jeweils benachbart zu der Vielzahl von Feuerlöschfluidspeichereinheiten (P1, P2, P3, P4) sind; und
eine Steuerschaltung (10), die ausgebildet ist, die Spannung (Vᵣ) zwischen den beiden Enden der Vielzahl von Widerstandseinheiten (R1, R2, R3, R4) zu überwachen und den durch jede der Vielzahl von Widerstandseinheiten (R1, R2, R3, R4) fließenden Strom zu erhöhen, wenn die Spannung höher als eine Referenzspannung (V_{ref}) ist, wobei
die Vielzahl von Widerstandseinheiten (R1, R2, R3, R4) elektrisch parallel zueinander geschaltet sind und jede Widerstandseinheit ein Heizpad umfasst, das durch Erhitzen zerstört wird, um den geschalteten Stromkreis zu öffnen, und
die Spannung zwischen den beiden Enden der Vielzahl von Widerstandseinheiten (R1, R2, R3, R4) höher als die Referenzspannung ist, wenn das in mindestens einer der Vielzahl von Widerstandseinheiten enthaltene Heizpad zerstört ist.

2. Batteriefeuerlöschvorrichtung nach Anspruch 1, wobei zu jeder Widerstandseinheit eine Feuerlöschfluidspeichereinheit (P1, P2, P3, P4) benachbart ist, die ausgebildet ist, durch Erhitzen Feuerlöschfluid abzugeben, wenn der durch jede der Vielzahl von Widerstandseinheiten fließende Strom ansteigt.

3. Batteriefeuerlöschvorrichtung nach Anspruch 1, wobei das Feuerlöschfluid ein Material umfasst, das verhindert, dass ein Elektrolytgas in dem Batteriemodul mit Sauerstoff in Kontakt kommt, und das eine Temperatur in dem Batteriemodul senkt.

4. Batteriefeuerlöschvorrichtung nach Anspruch 1, wobei die Steuerschaltung (10) Folgendes umfasst:
einen Vergleicher (110), der ausgebildet ist, die Spannung zwischen den beiden Enden der Vielzahl von Widerstandseinheiten mit der Referenzspannung zu vergleichen;
einen Serienwiderstand (Rᵣ), der seriell mit der Vielzahl von Widerstandseinheiten geschaltet ist;
eine Stromversorgungseinheit (130), die ausgebildet ist, die Vielzahl von Widerstandseinheiten und den mit dem Serienwiderstand geschalteten Stromkreis mit Strom zu versorgen; und
mindestens einen Schalter (121, 122), der ausgebildet ist, die Vielzahl von Widerstandseinheiten (R1, R2, R3, R4) elektrisch mit dem Serienwiderstand (Rᵣ) zu verbinden oder davon zu trennen,
wobei, wenn die Spannung zwischen den beiden Enden der Vielzahl von Widerstandseinheiten (R1, R2, R3, R4) höher als die Referenzspannung (V_{ref}) ist, die elektrische Verbindung zwischen der Vielzahl von Widerständen und dem Serienwiderstand blockiert wird, um den durch jede der Vielzahl von Widerstandseinheiten fließenden Strom zu erhöhen.

5. Batteriefeuerlöschvorrichtung nach Anspruch 4, wobei der Serienwiderstand (Rᵣ) einen größeren Widerstandswert als einen Gesamtwiderstandswert der Vielzahl von Widerstandseinheiten (R1, R2, R3, R4) aufweist.

6. Batteriefeuerlöschvorrichtung nach Anspruch 4, wobei die Steuerschaltung (10) weiter einen Regler (140) umfasst, der ausgebildet ist, die von der Stromversorgungseinheit gelieferte Spannung auf einem bestimmten Niveau zu halten und die Spannung an den Vergleicher zu liefern.

7. Betriebsverfahren einer Batteriefeuerlöschvorrichtung nach Anspruch 1, wobei das Betriebsverfahren Folgendes umfasst:
Überwachen (S410) der Spannung zwischen den beiden Enden einer Vielzahl von Widerstandseinheiten, die jeweils benachbart zu einer Vielzahl von Feuerlöschfluidspeichereinheiten sind, die jeweils in einem der Vielzahl von Batteriemodulen angeordnet sind; und
Erhöhen (S420) des durch jede der Vielzahl von Widerstandseinheiten fließenden Stroms, wenn die Spannung höher als eine Referenzspannung ist.

8. Betriebsverfahren nach Anspruch 9, wobei das Erhöhen des durch jede der Vielzahl von Widerstandseinheiten fließenden Stroms Folgendes umfasst:
Vergleichen (S520) der Spannung zwischen den beiden Enden der Vielzahl von Widerstandseinheiten mit der Referenzspannung; und
Steuern (S530) einer Schalteranordnung, um die elektrische Verbindung zwischen der Vielzahl von Widerstandseinheiten und einem Serienwiderstand, der einen größeren Widerstandswert als die Vielzahl von Widerstandseinheiten aufweist, zu blockieren, wenn die Spannung zwischen den beiden Enden der Vielzahl von Widerstandseinheiten höher als die Referenzspannung ist.

9. Betriebsverfahren nach Anspruch 8, das weiter das Erhitzen (S540) der Vielzahl von Widerstandseinheiten und der Feuerlöschfluidspeichereinheit umfasst, um Feuerlöschfluid aus der Feuerlöschfluidspeichereinheit abzugeben.

## Revendications

1. Appareil d'extinction d'incendie de batterie comprenant :
une pluralité d'unités de stockage de fluide d'extinction d'incendie (P1, P2, P3, P4) respectivement situées dans une pluralité de modules de batterie (M1, M2, M3, M4) et configurées pour décharger un fluide d'extinction d'incendie par chauffage ;
une pluralité d'unités de résistance (R1, R2, R3, R4) respectivement adjacentes à la pluralité d'unités de stockage de fluide d'extinction d'incendie (P1, P2, P3, P4) ; et
un circuit de commande (10) configuré pour surveiller la tension (Vᵣ) aux deux extrémités de la pluralité d'unités de résistance (R1, R2, R3, R4) et augmenter le courant circulant à travers chacune de la pluralité d'unités de résistance (R1, R2, R3, R4) lorsque la tension est supérieure à une tension de référence (V_{réf}), dans lequel
la pluralité d'unités de résistance (R1, R2, R3, R4) sont connectées électriquement entre elles en parallèle, et chaque unité de résistance comprend une pastille chauffante qui est détruite par chauffage pour ouvrir le circuit connecté, et
la tension aux deux extrémités de la pluralité d'unités de résistance (R1, R2, R3, R4) est supérieure à la tension de référence lorsque la pastille chauffante incluse dans au moins l'une de la pluralité d'unités de résistance est détruite.

2. Appareil d'extinction d'incendie de batterie selon la revendication 1, dans lequel une unité de stockage de fluide d'extinction d'incendie (P1, P2, P3, P4) adjacente à chaque unité de résistance est configurée pour décharger du fluide d'extinction d'incendie par chauffage, lorsque le courant circulant à travers chacune de la pluralité d'unités de résistance augmente.

3. Appareil d'extinction d'incendie de batterie selon la revendication 1, dans lequel le fluide d'extinction d'incendie comprend un matériau qui empêche un gaz électrolytique dans le module de batterie d'entrer en contact avec de l'oxygène et abaisse une température dans le module de batterie.

4. Appareil d'extinction d'incendie de batterie selon la revendication 1, dans lequel le circuit de commande (10) comprend :
un comparateur (110) configuré pour comparer la tension aux deux extrémités de la pluralité d'unités de résistance à la tension de référence ;
une résistance série (Rᵣ) connectée en série à la pluralité d'unités de résistance ;
une unité d'alimentation électrique (130) configurée pour alimenter la pluralité d'unités de résistance et le circuit connecté à la résistance série ; et
au moins un commutateur (121, 122) configuré pour connecter électriquement la pluralité d'unités de résistance (R1, R2, R3, R4) à la résistance série (Rᵣ) ou les déconnecter électriquement de celle-ci,
dans lequel, lorsque la tension aux deux extrémités de la pluralité d'unités de résistance (R1, R2, R3, R4) est supérieure à la tension de référence (V_{réf}), la connexion électrique entre la pluralité de résistances et la résistance série est bloquée pour augmenter le courant circulant à travers chacune de la pluralité d'unités de résistance.

5. Appareil d'extinction d'incendie de batterie selon la revendication 4, dans lequel la résistance série (Rᵣ) présente une valeur de résistance supérieure à une valeur de résistance totale de la pluralité d'unités de résistance (R1, R2, R3, R4).

6. Appareil d'extinction d'incendie de batterie selon la revendication 4, dans lequel le circuit de commande (10) comprend en outre un régulateur (140) configuré pour maintenir la tension fournie par l'unité d'alimentation électrique à un certain niveau et fournir la tension au comparateur.

7. Procédé de fonctionnement d'un appareil d'extinction d'incendie de batterie selon la revendication 1, le procédé de fonctionnement comprenant :
la surveillance (S410) de la tension aux deux extrémités d'une pluralité d'unités de résistance respectivement adjacentes à une pluralité d'unités de stockage de fluide d'extinction d'incendie respectivement situées dans une pluralité de modules de batterie ; et
l'augmentation (S420) du courant circulant à travers chacune de la pluralité d'unités de résistance lorsque la tension est supérieure à une tension de référence.

8. Procédé de fonctionnement selon la revendication 9, dans lequel l'augmentation du courant circulant à travers chacune de la pluralité d'unités de résistance comprend :
la comparaison (S520) de la tension aux deux extrémités de la pluralité d'unités de résistance à la tension de référence ; et
la commande (S530) d'un circuit de commutation pour bloquer une connexion électrique entre la pluralité d'unités de résistance et une résistance série présentant une valeur de résistance supérieure à la pluralité d'unités de résistance, lorsque la tension aux deux extrémités de la pluralité d'unités de résistance est supérieure à la tension de référence.

9. Procédé de fonctionnement selon la revendication 8, comprenant en outre le chauffage (S540) de la pluralité d'unités de résistance et de l'unité de stockage de fluide d'extinction d'incendie pour décharger le fluide d'extinction d'incendie depuis l'unité de stockage de fluide d'extinction d'incendie.
